# EUROPÄISCHE PATENTANMELDUNG

(11) **EP 1 162 655 A2**
(43) Veröffentlichungstag der Anmeldung: **12.12.2001**
(21) Anmeldenummer: 01113837.7
(22) Anmeldetag: 06.06.2001
(51) Int. Cl.: H01L 21/66

(54) **Integrierte Schaltungsanordnung zum Testen von Transistoren und Halbleiterscheibe mit einer solchen Schaltungsanordnung**

(30) Priorität: 07.06.2000 DE 10028145
(71) Anmelder: Infineon Technologies AG, 81669 München (DE)
(72) Erfinder: Gerstmeier, Günter, 27514 Chapel Hill, NC (US); Rosskopf, Valentin, Dr., 86554 Pöttmes (DE)
(74) Vertreter: Epping Hermann & Fischer

(57) **Zusammenfassung**

Schaltungsanordnungen zum Testen von Transistoren (T11, ..., T36) sind im Ritzrahmen zwischen integrierten Schaltungen auf einem Halbleiterwafer angeordnet. Um die Anzahl der testbaren Transistoren bei geringem Flächenverbrauch zu erhöhen, werden die Transistoren (T11, ..., T36) matrixartig in mindestens zwei Zeilen angeordnet. Die Drain-Source-Pfade der Transistoren der ersten Zeile (T11, ..., T16) sind zwischen Anschlußpads (P11, ..., P6) geschaltet und deren Gateanschlüsse sind an ein gemeinsames Anschlußpad (P1) angeschlossen. Die Drain-Source-Pfade der Transistoren der zweiten Zeile (T21, ..., T26) sind einerseits an eines der Anschlußpads (P11, ..., P6) angeschlossen und andererseits gemeinsam an ein weiteres Anschlußpad (P4). Deren Gateanschlüsse sind ebenfalls an ein weiteres Anschluß pad (P2) angeschlossen. Die matrixartige Anordnung der Transistoren ist mit zusätzlichen Zeilen (T31, ..., T36) erweiterbar.

## Beschreibung

Die Erfindung betrifft eine integrierte Schaltungsanordnung zum Testen von Transistoren mit Anschlußflächen, an die die Transistoren angeschlossen sind.

Integrierte Schaltkreise werden bekanntlich auf Halbleiterscheiben oder Wafern hergestellt. Auf einem Wafer ist eine Vielzahl von Schaltkreisen, meist gleichen Typs, angeordnet. Der Wafer wird zur Herstellung der die Schaltungen bildenden Transistoren einer Vielzahl von Prozeßschritten unterzogen. Nach verschiedenen Prozeßschritten werden die mechanischen und elektrischen Eigenschaften der gefertigten Strukturen und Schaltungen getestet. Anschließend werden die auf dem Wafer angeordneten einzelnen Schaltkreise auseinander gesägt, so daß einzelne Halbleiterplättchen, sogenannte Chips entstehen. Die im Betreff genannte Testschaltungsanordnung befindet sich auf dem Wafer zwischen den einzelnen Chips im Ritzrahmen, dem sogenannten Kerf. Die im Kerf angeordneten zu testenden Transistoren sind über Anschlußflächen, sogenannte Pads, zugänglich. Die Erfindung betrifft außerdem eine solche Halbleiterscheibe.

Es besteht stets das Bestreben, möglichst viele Chips auf einem Wafer unterzubringen. Man ist daher bestrebt, den Zwischenraum zwischen den Chips möglichst klein zu halten. Andererseits möchte man möglichst viele der genannten Transistoren testen, um ausreichend viele Parameter zu erhalten, um über die Qualität des hergestellten Wafers eine möglichst umfassende Aussage treffen zu können. Um im Kerf angeordnete Transistoren zu testen, sind daher weitere Anschlußflächen vorgesehen. Da die Anschlußflächen zur Aufnahme von Meßspitzen oder Probe-Nadeln eines Testautomaten dienen, benötigen sie wesentlich mehr Fläche als die zu testende Transistorstruktur. Bei einer etwa 1:1-Zuordnung zwischen zu testenden Transistoren und Testpads nimmt der Flächenbedarf unverhältnismäßig stark zu. Dem Wunsch, die verfügbare Waferfläche mit nutzbaren integrierten Schaltungen möglichst optimal auszunutzen, widerstrebt das Bedürfnis möglichst viele Testparameterwerte und somit zu testende Transistoren vorzusehen.

In der EP-A-0 430 372 ist eine Teststruktur zum Testen von integrierten Schaltungen gezeigt, die im Kerf des Halbleiterwafers zwischen den zu testenden integrierten Schaltungen angeordnet ist. Aus den Teststrukturen werden Prozeßparameter abgeleitet. Um Bondpads für diese Teststrukturen zu sparen, ist eine Multiplexschaltung vorgesehen, die verschiedene Teststrukturen an die gleichen Anschlußverbindungen ankoppelt.

In der DE-A-198 19 570 ist eine Testlogik beschrieben, die im Kerfbereich des Halbleiterwafers angeordnet ist und Testsignale für den dem Kerf benachbarten Halbleiterchip bereitstellt. Weitere Steuersignale sowie die Versorgungsspannung werden über Nadeln den auf der integrierten Schaltung angeordneten Anschlußpads zugeführt.

In der DE-A-198 31 563 ist die Anordnung von Anschlußpads im Kerf eines Halbleiterwafers gezeigt, über die Testsignale an mehrere Chips gemeinsam bereitstellbar sind.

Eine Aufgabe der vorliegenden Erfindung besteht darin, eine Schaltungsanordnung zum Testen von Transistoren anzugeben, die bei möglichst vielen zu testenden Transistoren möglichst geringen Flächenverbrauch bei integrierter Realisierung aufweist.

Gemäß der Erfindung wird diese Aufgabe durch eine integrierte Schaltungsanordnung zum Testen von Transistoren gelöst, die umfaßt: eine erste Vielzahl von Anschlußflächen zur Zuführung und zum Abgriff von Signalen, eine zweite Vielzahl von den zu testenden Transistoren, die in mindestens zwei Zeilen angeordnet sind, wobei jeweils einer der Transistoren einer ersten Zeile zwischen zwei Anschlußflächen angeordnet ist und die Anschlüsse des gesteuerten Pfades dieses Transistors mit diesen zwei Anschlußflächen verbunden ist und die Steueranschlüsse aller Transistoren der ersten Zeile mit einer ersten weiteren Anschlußfläche verbunden sind, einer der Anschlüsse des gesteuerten Pfades je eines der Transistoren einer zweiten Zeile mit je einer verschiedenen der Anschlußflächen verbunden ist, der andere der Anschlüsse des gesteuerten Pfades dieser Transistoren gemeinsam mit einer zweiten weiteren Anschlußfläche verbunden sind und die Steueranschlüsse dieser Transistoren gemeinsam mit einer dritten weiteren Anschlußfläche verbunden sind.

Bei der Testschaltungsanordnung gemäß der Erfindung ist eine zusätzliche Zeile von zu testenden Transistoren angeordnet, die an die bereits bisher vorhandenen Testpads angeschlossen sind und darüber hinaus nur zwei zusätzliche Testpads erfordern, die von diesen Transistoren gemeinsam benutzt werden. Trotz einer Verdopplung von testbaren Transistoren durch Hinzufügen einer neuen Zeile von zu testenden Transistoren erhöht sich der Flächenverbrauch aufgrund von nur zwei weiteren Testpads nicht wesentlich. Im allgemeinen ist die Erfindung dahingehend offen, daß eine prinzipiell beliebige Anzahl von weiteren Zeilen mit zu testenden Transistoren in entsprechender Weise angeordnet wird. Der wesentliche Vorteil besteht darin, daß bereits vorhandene Anschlußpads mehrfach genutzt werden. Da Anschlußpads den weitaus größeren Flächenverbrauch gegenüber zusätzlichen Transistoren aufweisen, wird der Mehrbedarf an Flächen im wesentlichen nur durch die zusätzlichen Transistoren und die gemeinsam genutzten zusätzlichen Anschlußpads bestimmt. Der zusätzliche Aufwand an Verdrahtung tritt demgegenüber zurück. Allenfalls ist die Anzahl zusätzlich vorgesehener Zeilen aus zu testenden Transistoren beschränkt durch die dann eingeschränkte Flexibilität bei der Verdrahtung.

Gemäß einem weiteren Gesichtspunkt der Erfindung enthält ein Halbleiterwafer die Testschaltung im Zwischenraum zwischen den kommerziell nutzbaren integrierten Schaltungen. Dieser Zwischenraum wird herkömmlicherweise anschließend verwendet, um die nutzbaren integrierten Schaltungschips auseinander zu sägen und dadurch voneinander zu trennen.

Die Anschlußflächen oder Pads sind vorgesehen, um Meßspitzen eines Testautomaten darauf aufzusetzen, um elektrische Signale einzuprägen und abzugreifen. Der Testautomat ist entsprechend zu konfigurieren und zu programmieren, um mit den Testschaltungsstrukturen gemäß der Erfindung zusammenwirken zu können.

Im Hinblick auf vorteilhafte Ausgestaltungen der Erfindung ist auf die abhängigen Ansprüche verwiesen.

Sowohl die Anschlußflächen als auch die Transistoren einer jeden Zeile sind längs jeweiliger Geraden ausgerichtet. Die Zeile der Transistoren und die Anordnung der Pads verlaufen zweckmäßigerweise parallel zueinander.

Die zu testenden Transistoren sind die jeweiligen Transistoren des Typs der integrierten Schaltung. Wenn zur Herstellung des Wafers komplementäre MOS-Prozeßtechnologie angewandt wird, sind die Transistoren MOS-Feldeffekttransistoren. Die Transistoren weisen einen gesteuerten Strompfad auf, der endseitig Drain- und Sourceanschlüsse hat. Dieser Strompfad ist von einer Steuerelektrode, dem Gate, in seinem Leitverhalten steuerbar. Die Transistoren sind matrixartig angeordnet. Das bedeutet, daß zwei Richtungen von Geraden vorliegen, längs deren die Transistoren ausgerichtet sind. Die eine der Geraden verläuft parallel zur Ausrichtung der Pads, wie oben gesagt. Die andere der Geraden verläuft quer dazu und schneidet die erstgenannte. Vorzugsweise stehen die Geraden senkrecht zueinander, so daß sich eine matrixartige, schachbrettartige Rasterstruktur ergibt.

Nachfolgend wird die Erfindung anhand der in der Zeichnung dargestellten Figuren näher erläutert. Es zeigen:
- Figur 1: eine schaltungstechnische Detailansicht einer Testschaltung gemäß der Erfindung und
- Figur 2: eine Aufsicht auf einen Halbleiterwafer, der diese Strukturen umfaßt.

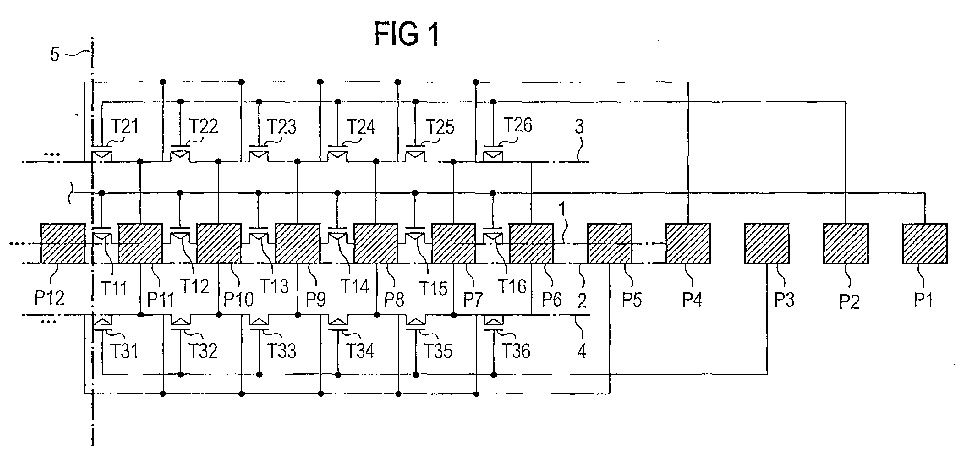

Gemäß Figur 1 enthält die Teststruktur gemäß der Erfindung eine Vielzahl von Anschlußflächen, sogenannten Pads P1, ..., P12. Eine solche Anschlußfläche ist bekanntlich eine rechtekkige oder quadratische Metallisierung, die nicht passiviert ist und von der Oberfläche des Halbleiterchips her zugänglich ist, beispielsweise zum Aufsetzen einer Meßspitze. Eine erste Zeile von zu testenden Transistoren umfaßt die Transistoren T11, ..., T16. Die Drain- und Sourceanschlüsse der Transistoren T11, ..., T16 sind zwischen je zwei unmittelbar benachbarten Anschlußpads angeschlossen. So ist beispielsweise einer der Anschlüsse der Drain-Source-Strecke des Transistors T11 mit dem Anschlußpad 12 verbunden, der andere der Anschlüsse der Drain-Source-Strecke des Transistors T11 ist mit dem Pad P11 verbunden. Die Steueranschlüsse oder Gateelektroden der Transistoren T11, ..., T16 sind gemeinsam an ein weiteres Pad P1 angeschlossen. Jeder der Transistoren T11, ..., T16 ist durch eine entsprechende Steuerspannung, die über das Pad P1 eingekoppelt wird, steuerbar, so daß an den verschiedenen Transistoren unterschiedliche Parameter gemessen werden können. Oft weist jeder der Transistoren eine besondere Gestaltung auf, so daß ein individueller Prozeßparameter gemessen werden kann, der auf jeweilige Verhältnisse während der Herstellung des Wafers entsprechende Rückschlüsse ermöglicht.

Die Pads sind so groß zu dimensionieren, daß im Rahmen der herkömmlichen Positionierungsgenauigkeit eine Meßspitze zielsicher aufgesetzt werden kann. Die Transistoren weisen demgegenüber einen kleineren Flächenverbrauch auf. Die Strukturen der Transistoren befinden sich zwischen den jeweiligen Pads, an welche die Drain- und Sourceanschlüsse der Transistoren angeschlossen sind.

Die Transistoren T11, ..., T16 weisen regelmäßige Struktur auf. Sie sind längs einer gedachten Geraden 1 angeordnet. Dies bedeutet, daß ein charakteristisches Merkmal jedes der Transistoren T11, ..., T16 in gleicher Weise an der Geraden 1 ausgerichtet ist. Die Pads P5, ..., P12 sind vorzugsweise gleich groß ausgeführt. Sie sind längs einer Geraden 2 ausgerichtet. Dies bedeutet, daß jeweils die gleiche Seite der rechteckförmigen Padfläche in gleicher Weise an der Geraden 2 ausgerichtet ist. Die Geraden 1 und 2 verlaufen parallel zueinander, so daß sowohl die Folge der Pads P6, ..., P12 als auch die Folge der Transistoren T11, ..., T16 je eine Zeile bilden, die parallel zueinander verlaufen.

Es ist eine weitere Zeile von Transistoren T21, ..., T26 vorgesehen, wobei diese Transistoren längs einer Geraden 3 ausgerichtet sind. Einer der Anschlüsse der Drain-Source-Pfade der Transistoren T21, ..., T26 ist an je eine Anschlußfläche P11, ..., P6 angeschlossen. Die jeweiligen anderen Anschlüsse der Drain-Source-Strecken der Transistoren T21, ..., T26 sind miteinander verbunden und gemeinsam an ein weiteres Pad P4 angeschlossen. Ebenso sind die Gateanschlüsse der Transistoren T21, ..., T26 miteinander verbunden und gemeinsam an ein Pad P2 angeschlossen. Auf diese Weise ist der Leitungszustand der Transistoren T21, ..., T26 über eine Signaleinprägung am Pad P2 steuerbar. Ein zu messender Parameter ist daraufhin zwischen dem Pad P4 und dem jeweiligen anderen an die Drain-Source-Strecke der Transistoren angeschlossenen Pads P6, ..., P11 abgreifbar.

Die Gerade 3, an welcher die Transistoren T21, ..., T26 ausgerichtet sind, verläuft parallel zu den anderen Geraden 1 oder 2. Darüber hinaus sind je zwei Transistoren, z.B. die Transistoren T11 und T21, längs einer weiteren Geraden 5 ausgerichtet, die die Geraden 1, 2 oder 3 schneidet. Im Ausführungsbeispiel steht die Gerade 5 auf die Geraden 1, 2, 3 senkrecht. Dies gilt in entsprechender Weise für die anderen Transistoren T22, ..., T26 der zweiten Zeile. Dadurch ergibt sich insgesamt eine matrixartige, schachbrettartige Anordnung, bei der jeweils die gleichen charakteristischen Strukturelemente der Transistoren an Rasterpunkten eines Gitternetzes liegen, dessen Gitterpunkte regelmäßig angeordnet sind und senkrecht bzw. parallel zueinander verlaufende Verbindungslinien aufweisen.

Wie in Figur 1 dargestellt ist die Erfindung um eine dritte Zeile von Transistoren T31, ..., T36 erweiterbar. Die Transistoren T31, ..., T36 sind längs einer Geraden 4 parallel zu den bisherigen Geraden 1, 2 und 3 ausgerichtet. Außerdem ist der Transistor T31 längs der Geraden 5 wie die Transistoren T11 und T21 ausgerichtet. Entsprechend zu der Zeile der Transistoren T21, ..., T26 sind die Transistoren T31, ..., T36 in der Weise verschaltet, daß deren Gateanschlüsse gemeinsam an ein Anschlußpad P3 angeschlossen sind und die einen Anschlüsse von deren Drain-Source-Strecken gemeinsam an ein Anschlußpad P5. Die anderen Anschlüsse von deren Drain-Source-Strecken sind jeweils an eines der Anschlußpads P11, ..., P6 angeschlossen.

Es ist ohne weiteres möglich, weitere Zeilen von Transistoren anzuordnen und in entsprechender Weise zu beschalten. Die Gateanschlüsse sind jeweils an ein zusätzliches Pad gemeinsam anzuschließen, ebenso jeweils eine der Anschlüsse von deren Drain-Source-Strecken. Der andere Anschluß von deren Drain-Source-Strecken ist jeweils an eines der Pads P11, ..., P6 anzuschließen. Die Anzahl möglicher weiterer Zeilen von Transistoren wird praktischerweise nur durch die zunehmende Komplexität und dadurch eingeschränkte Flexibilität bei deren Verdrahtung beschränkt. Die Anzahl der in Richtung der Geraden 1, ..., 4 anordenbaren Transistoren bzw. Pads ist nahezu beliebig. Die Erfindung hat dabei den Vorteil, daß die vorhandenen Pads, z.B. die Pads P12, ..., P6, mehrfach für verschiedene Zeilen von zu testenden Transistoren genutzt werden. Jede zusätzliche Transistorzeile erfordert unabhängig von der Anzahl der Transistoren nur zwei weitere Pads, nämlich diejenigen, an denen deren Gateanschlüsse und ein Anschluß von deren Drain-Source-Strecke gemeinsam angeschlossen sind. Der zusätzlich Flächenbedarf für weitere zu testenden Transistoren wird daher im wesentlichen nur noch durch den Flächenbedarf für die hinzugefügten Transistoren bestimmt, dem gegenüber der Flächenbedarf für die zusätzlichen Anschlußpads zurücktritt.

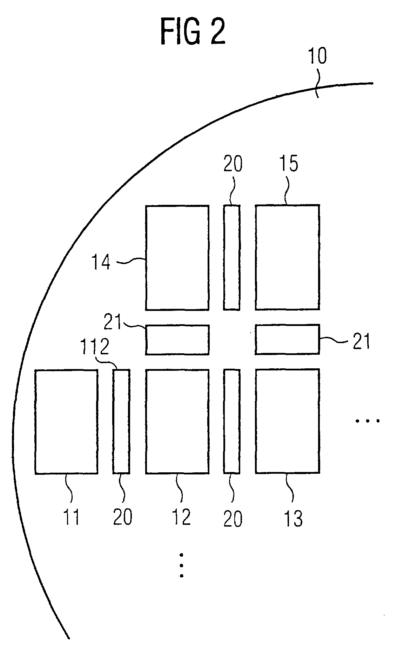

Die Figur 2 zeigt einen Halbleiterwafer 10 mit einer Vielzahl von rechteckigen integrierten Schaltungen, die nach Abschluß der Herstellung und entsprechender Tests auseinander gesägt werden. Hierzu sind die Halbleiterchips, z.B. 11, 12, durch einen Zwischenraum 112 voneinander getrennt. Dieser Zwischenraum wird Ritzrahmen oder Kerf genannt. Jede einzelne der integrierten Schaltungen 11, 12 etc. wird anschließend in ein Gehäuse gegossen, um in einem elektronischen Gerät Anwendung zu finden. Beispielsweise sind die integrierten Schaltungen 11, 12 integrierte Halbleiterspeicher. Im Kerf 112 und in den weiteren Kerfs, beispielsweise zwischen den Chips 12 und 13 sowie 14 und 15, sind jeweilige Testschaltungsanordnungen 20 mit einem Aufbau entsprechend der Darstellung in Figur 1 angeordnet. Je nach Testanforderungen können auch in horizontaler Richtung im Kerf zwischen den integrierten Schaltungen, z.B. 12 und 14 sowie 13 und 15, Testschaltungsanordnungen 21 im Aufbau entsprechend der Figur 1 vorgesehen sein. Die Testschaltungen 20, 21 dienen dazu, am Ende des Herstellungsprozesses des Wafers vor dem Zersägen charakteristische Transistorparameter verschiedenster Art zu messen. Da die Teststrukturen nachfolgend nicht mehr benötigt werden, werden sie beim Auseinandersägen zerstört.

## Patentansprüche

1. Integrierte Schaltungsanordnung zum Testen von Transistoren, umfassend:
- eine erste Vielzahl von Anschlußflächen (P6, ..., P12) zur Zuführung und zum Abgriff von Signalen,
- eine zweite Vielzahl von den zu testenden Transistoren (T11, ..., T16, T21, ..., T26), die in mindestens zwei Zeilen angeordnet sind, wobei
- jeder der Transistoren (T11) einer ersten Zeile zwischen je zwei Anschlußflächen (P12, P11) angeordnet ist und die Anschlüsse des gesteuerten Pfades dieser Transistoren (T11) mit diesen zwei Anschlußflächen (P12, P11) verbunden sind und die Steueranschlüsse aller Transistoren (T11 ..., T16) der ersten Zeile mit einer ersten weiteren Anschlußfläche (P1) verbunden sind,
- einer der Anschlüsse des gesteuerten Pfades jedes der Transistoren (T21) einer zweiten Zeile mit je einer verschiedenen der Anschlußflächen verbunden ist (P11), die anderen der Anschlüsse des gesteuerten Pfades dieser Transistoren (T21, ..., T26) gemeinsam mit einer zweiten weiteren Anschlußfläche (P4) verbunden sind und die Steueranschlüsse dieser Transistoren (T21, ..., T26) gemeinsam mit einer dritten weiteren Anschlußfläche (P2) verbunden sind.

2. Integrierte Schaltungsanordnung nach Anspruch 1,
**dadurch gekennzeichnet, daß**
die Anschlußflächen (P12, ..., P6) und weiteren Anschlußflächen (P1, P2, P4) längs einer ersten Geraden (2) angeordnet sind, daß die Transistoren (T11, ..., T16) der ersten Zeile längs einer zweiten Geraden (1) angeordnet sind, die parallel zur ersten Geraden (2) verläuft, und daß die Transistoren (T21, ..., T26) der zweiten Zeile längs einer dritten Geraden (3) angeordnet sind, die parallel zur ersten oder zweiten Gerade (1, 2) verläuft.

3. Integrierte Schaltungsanordnung nach Anspruch 1 oder 2,
**dadurch gekennzeichnet, daß**
die Transistoren (T11, ..., T26) Feldeffekttransistoren sind, deren gesteuerter Pfad der Drain-Source-Pfad und deren Steueranschluß der Gateanschluß der Feldeffekttransistoren ist.

4. Integrierte Schaltungsanordnung nach einem der Ansprüche 1 bis 3,
**dadurch gekennzeichnet, daß**
mindestens eine weitere Zeile von Transistoren (T31, ..., T36) vorgesehen ist, daß einer der Anschlüsse der gesteuerten Pfade je eines der Transistoren (T31) mit je einer verschiedenen der Anschlußflächen (P11) verbunden ist und daß der andere der Anschlüsse des gesteuerten Pfades der Transistoren (T31, ..., T36) der weiteren Zeile gemeinsam mit einer vierten weiteren Anschlußfläche (P5) verbunden ist und daß die Steueranschlüsse der Transistoren (T31, ..., T36) der weiteren Zeile gemeinsam mit einer fünften weiteren Anschlußfläche (P3) verbunden sind.

5. Integrierte Schaltungsanordnung nach Anspruch 4,
**dadurch gekennzeichnet, daß**
je einer der Transistoren (T21, T11, T31) der ersten, zweiten und weiteren Zeile längs einer Geraden (5) angeordnet ist, die die anderen Geraden (1, 2, 3) schneidet.

6. Integrierte Schaltungsanordnung nach einem der Ansprüche 1 bis 5,
**gekennzeichnet durch**
matrixartige Anordnung der Transistoren in Zeilen und quer dazu verlaufenden Spalten.

7. Halbleiterscheibe, umfassend mindestens zwei integrierte Schaltungen (11, 12, 13, 14, 15) und eine integrierte Schaltungsanordnung (20, 21) zum Testen von Transistoren nach einem der Ansprüche 1 bis 6, die zwischen den zwei integrierten Schaltungen (11, 12, 13, 14, 15) angeordnet ist.
